**Europäisches Patentamt**

**European Patent Office**

**Office européen des brevets**

(19)

(11) Veröffentlichungsnummer: **0 090 079**
**B1**

(12) # EUROPÄISCHE PATENTSCHRIFT

(45) Veröffentlichungstag der Patentschrift: **29.07.87**

(51) Int. Cl.⁴: **G 02 F 1/133, H 05 K 3/30**

(21) Anmeldenummer: **82110642.4**

(22) Anmeldetag: **18.11.82**

(54) Substrat.

(30) Priorität: **27.03.82 DE 3211408**

(43) Veröffentlichungstag der Anmeldung:
**05.10.83 Patentblatt 83/40**

(45) Bekanntmachung des Hinweises auf die
Patenterteilung:
**29.07.87 Patentblatt 87/31**

(84) Benannte Vertragsstaaten:
**FR GB IT NL**

(56) Entgegenhaltungen:
**EP-A-0 042 920**
**US-A-3 959 876**
**US-A-3 989 353**

(73) Patentinhaber: **VDO Adolf Schindling AG**
**Gräfstrasse 103**
**D-6000 Frankfurt/Main (DE)**

(72) Erfinder: **Nickol, Friedrich Wilhelm**
**Am Honigbaum 35**
**D-6239 Eppstein 4 (DE)**

(74) Vertreter: **Könekamp, Herbert, Dipl.-Ing.**
**Sodener Strasse 9**
**D-6231 Schwalbach (DE)**

Courier Press, Leamington Spa, England.

### Beschreibung

Die Erfindung bezieht sich auf ein Substrat mit darauf in dichtem Abstand angeordneten Leiterbahnen aus einem lötfähigen Material sowie mit einer auf die Leiterbahnen- durch Kontakt bei Entlangbewegung der Leiterbahnen an schmelzflüssigem Lotmaterial aufgebrachten Lotschicht.

Derartige Substrate sind bekannt (US—A—3 959 876, US—A—3 989 353. EP—A—0 042 920). Beim Aufbringen der Lotschicht wird die Leiterbahn an dem schmelzflüssigen Lotmaterial entlangbewegt und kommt mit diesem in Kontakt. Das Lotmaterial bleibt an der Leiterbahn haften. Insbesondere, wenn die Leiterbahn quer zu ihrer Längserstreckung am schemlzflüssigen Lotmaterial entlang bewegt wird, führt die Adhäsion des Lotmaterials dazu, daß das auf die Leiterbahn aufgebrachte Lotmaterial mit dem aufzubringenden Lotmaterial auch dann noch einen Moment verbunden ist, wenn die Leiterbahn bereits von diesem Lotmaterial wegbewegt ist. Erst bei Erreichen eines bestimmten Abstandes reißt diese Verbindung ab. Dabei zieht sich ein Teil des die Verbindung bildenden Lotmaterials auf die bereits mit einer Lotschicht versehen Leiterbahn zurück. Damit erhält die Leiterbahn aber eine Lotschicht mit einer zu großen Dicke.

Bei mehreren Leiterbahnen, von denen die einen sich in Bewegungsrichtung und die anderen sich quer zur Bewegungsrichtung des sich an dem Lotmaterial vorbeibewegenden Substrats erstrecken, führt der oben beschriebene Effekt zu wesentlich dickeren Lotschichten bei den quer verlaufenden Leiterbahnen als bei den längs verlaufenden Leiterbahnen.

Die Dicke der Lotschicht ist auch abhängig von der Breite der Leiterbahn. Dies liegt daran, daß bei breiten Leiterbahnen die Lotschicht eine gewölbte Querschnittsform annimmt und somit mittig eine wesentlich größere Höhe besitzt als am Rand.

Sollen die breiten Leiterbahnen als Anschlüsse für Steckkontakte dienen, so kommt es schon bei kleinen Erschütterungen zu einem Abrutschen der Steckkontakte von der gewölbten Leiterbahn.

Ein weiterer Nachteil der großen Lotquerschnitte besteht darin, daß es aufgrund der Volumenkontraktion der Lotschicht beim Übergang vom Liquidus- in den Soliduszustand, die etwa 90% beträgt, zu großen Spannungen zwischen der mit dem Lot beschichteten Leiterbahn und dem Substrat kommt. Bei einem Glassubstrat, das in seinem Randbereich breite Leiterbahnen als Steckkontakte besitzt, führt dies häufig zum Ausbrechen des Glases.

Aufgabe der Erfindung ist es ein Substrat nach dem Oberbegriff zu schaffen, bei dem das Lotmaterial mit gleichmäßiger Dicke geringer Toleranzabweichung auf die Leiterbahn aufgebracht ist.

Diese Aufgabe wird erfindungsgemäß dadurch gelöst, daß auf dem Substrat neben den Leiterbahnen Scheinleiterbahnen vorgesehen sind, die einer Leiterbahn in ihrem Aufbau entsprechen aber keine elekrische Leitfunktion erfüllen, wobei die Leiterbahnen und Scheinleiterbahnen so angeordnet sind, daß beim Aufbringen der Lotschicht auf die Leiterbahnen und Scheinleiterbahnen das schmelzflüssige Lotmaterial immer in Kontakt mit einer Leiterbahn oder Scheinleiterbahn ist.

Die Scheinleiterbahnen Können dabei vorzugsweise etwa parallel zu Leiterbahnen in einem Abstand zwischen 20 μm bis 500 μm, vorzugsweise 100 μm, angeordnet sein. Diese erfindungsgemäße Ausbildung führt dazu, daß beim Aufbringen der Lotschicht auf die Leiterbahn die Verbindung zwischen dem Lotmaterial der Lotschicht und dem Schmelzflüssigen Lotmaterial sofort nach dem Vorbeibewegen der Leiterbahn an dem Lotmaterial unterbrochen wird, da dieses Lotmaterial zu diesem Zeitpunkt bereits mit einer neben der ersten Leiterbahn angeordneten zweiten Leiterbahn oder einer Scheinleiterbahn in Kontakt ist. An der immer in Bewegungsrichtung an letzter Stelle angeordneten Scheinleiterbahn kann dann beim Austauchen des Substrats aus dem Lotmaterial das nachgezogene Lot ablaufen.

Do somit sich kein überflüssiges Lotmaterial aufgrund van Adhäsion auf der Leiterbahn absetzen kann, ist es möglich, die Dicke der Lotschicht gleichmäßig innerbalb geringer Toleranzgrenzen herzustellen.

Selbst bei feinster Struktur mehrer Leiterbahnen, die dicht beieinanderliegen, kommt es nicht zu einem Kurzschluß zwischen den Leiterbahnen durch eine zu große Lotmaterialmenge, die zu einer Überbrückung des zwischen den Leiterbahnen vorhandenen Zwischenraums führen könnte. Trotzdem erfolgt der einwandfreie Lotauftrag selbst bei automatischem Durchlaufverfahren mit einer hohen Sicherheit.

Sind eine Mehrzahl Leiterbahnen auf einem Substrat angeordnet, wie z.B. bei einer Zellenwand einer Flüssigkristallzelle, in deren Randbereich elektronische Bauelemente wie integrierte Schaltkreise an die Leiterbahnen angelötet werden sollen, ist die gleiche Dicke der mit der Lotschicht versehenen Leiterbahnen von großer Wichtigkeit. Das Auflöten der Bauelemente erfolgt nämlich mittels eines von oben auf das Substrat aufgesetzten Stempels, der bei ungleichen Leiterbahnen und Lotdicken nicht an allen Stellen auf der dem Substrat aufgebrachten Leiter zur Auflage kommt. Dies führt zu fehlerhaften Lötverbindungen und somit au Ausschußproduktion.

Sind auf einem Substrat mehrere Leiterbahnen angeordnet, zwischen denen ein größerer Abstand besteht, so kann zwischen zwei in größerem Abstand voneinander verlaufenden Leiterbahnen eine Mehrzahl von Scheinleiterbahnen angeordnet sein, die vorzugsweise ein Raster bilden.

Ist das Substrat ein Glassubstrat, so wird die sonst übliche Gefährdung des Ausbrechens am Glasrand aufgrund von großen Wärmespannungen vermieden, da die vorhandene Wärmekapazität aufgrund der geringen Lotschichtdicke gering gehalten werden kann.

Die Leiterbahnen bestehen vorzugsweise aus Kupfer und können in einem fotolithographischen Verfahren hergestellt sein. Als Lotmaterial ist es günstig ein zinnhaltiges Material zu verwenden.

Die Lotschicht der Leiterbahn kann eine dicke von 2—50 μm, vorzugsweise 15 μm, aufweisen und kann mit einer Toleranz von ± 3 μm aufgebracht sein.

Eine großflächige Leiterbahn kann durch eine eine entsprechende Fläche abdeckende Mehrzahl untereinander verbundener feinstrukturierter Leiterbahnen gebildet sein. Dadurch wird vermieden, daß das Lotmaterial sich zu einem kegelförmigen Querschnitt wölbt, sondern in gleicher Dicke die einzelnen feinstrukturierten Leiterbahnen bedeckt. Außerdem wird die Gefahr des Ausbrechens von teilen des Substrats aufgrund von Wärmespannungen unterbunden. Dies ist besonders wichtig, wenn dei großflächige Leiterbahn eine im Randbereich des Substrats angeordnete Kontakstelle für einen Steckkontakt bildet, da die Gefährdung des Ausbrechens im Randbereich des Substrats besonders hoch ist. Ein Abrutschen des Steckkontakts von einer kegelförmigen Kontaktstelle ist nicht mehr möglich.

Eine besonders vorteilhafte Anwendung der Erfindung ist gegeben, wenn das Substrat eine Zellenwand einer Flüssigkristallzelle ist und die Leiterbahnen die Anschlüsse für Steuereinheiten bilden.

Ein Ausführungsbeispiel der Erfindung ist in der Zeichnung dargestellt und wird im flogenden näher beschrieben. Es zeigen

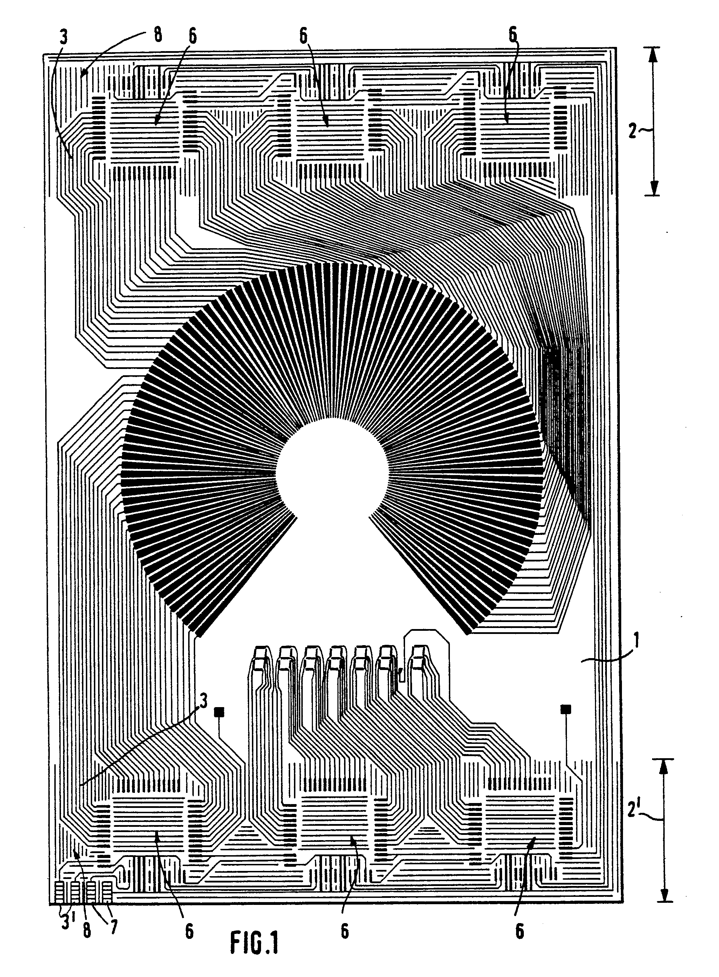

Figur 1 eine Ansicht eines erfindungsgemäßen Substrats

Figur 2 einen ausschnittsweisen Querschnitt des Substrats nach Figur 1

Das in den Figuren dargestellte Substrat ist ein Glassubstrat 1 und bildet eine Zellenwand einer Flüssigkristallzelle. In den Seitenbereichen 2 und 2' bestehen die auf dem Glassubstrat 1 in dichtem Abstand nebeneinander angeordneten Leiterbahnen 3 und Scheinleiterbahnen 4 aus Kupfer und sind mit einer Lotschicht 5 aus Zinn versehen. Die Leiterbahnen 3 sind direkt oder über in den Bereichen 6 auflötbare nicht dargestellte integrierte Schaltkeise mit großflächigen Kontaktstellen 7 verbunden, während die Scheinleiterbahnen 4 nur die freien Stellen zwischen den Leiterbahnen 3 in den Seitenbereichen 2 und 2' in Form von Rastern 8 ausfüllen und keine eletrische Leiterfunktion erfüllen.

Die im Randbereich des Glassubstrats 1 angeordneten großflächigen Kontaktstellen 7 dienen zum Anschluß für nicht dargestellte Steckkontakte. Die Kontaktstellen 7 bestehen aus einer Mehrzahl untereinander verbundener, feinstrukturierter Leiterbahnen 3', die netzartig die Fläche der Kontaktstellen 7 überdecken.

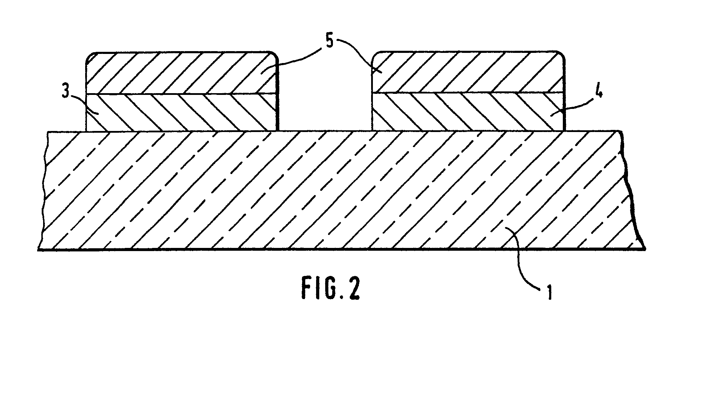

Ein Querschnitt der mit Zinn beschichteten Leiterbahnen 3 bzw. der Scheinleiterbahnen 4 ist in Figur 2 in vergrößertem Maßstab dargestellt. Dabei besitzt die aus Zinn bestehende Lotschicht 5 eine Dicke von 15 μm. Sie ist derart aufgetragen worden, daß das Glassubstrat 1 mit den vorher in einem Fotolithographieverfahren aufgebrachten Leiterbahnen 3 und Scheinleiterbahnen 4 an schmelzflüssigem zinnhaltigen Material entlangbewegt wurde.

Da bei dieser Entlangbewegung sie das zinnhaltige Material immer in Kontakt einer Leiterbahn 3, 3' oder Scheinleiterbahn 4 und damit mit dem Glassubstrat ist, kommt es während der gessamten Entlangbewegung zu keinem Abreißen dieses Materials von dem Glassubstrat 1. Dies führt dazu, daß die Verbindung zwischen Lotmaterial und Leiterbahn 3, 3' bzw. Scheinleiterbahn 4 sofort nach der Vorbeibewegung unterbrochen wird und keine überflüssige Menge Lotmaterial auf der Leiterbahn 3, 3' bzw. Scheinleiterbahn 4 verbleibt. Damit wird erreicht, daß die Lotschicht 5 allen Stellen der Seitenbereiche 2 und 2' mit gleicher Dicke innerhalb einer Toleranz von ± 3 μm und ohne Brückenbildung zwischen den nebeneinanderliegenden Leiterbahnen 3, 3' und Scheinleiterbahnen 4 aufbringbar ist.

**Patentansprüche**

1. Substrat mit darauf in dichtem Abstand angeordneten Leiterbahnen aus einem lötfähigen Material sowie mit einer auf die Leiterbahnen durch Kontakt bei Entlangbewegung der Leiterbahnen an schmelzflüssigem Lotmaterial aufgebrachten Lotschicht, dadurch gekennzeichnet, daß auf dem Substrat neben den Leiterbahnen (3, 3') Scheinleiterbahnen (4) vorgesehen sind, die einer Leiterbahn (3, 3') in ihrem Aufbau entsprechen aber keine elektrische Leitfunktion erfüllen, wobei dei Leiterbahnen (3, 3') und Scheinleiterbahnen (4) so angeordnet sind, daß beim Aufbringen der Lotschicht (5) auf die Leiterbahnen (3, 3') und Scheinleiterbahen (4) das schmelzflüssige Lotmaterial immer in Kontakt mit einer Leiterbahn (3, 3') oder Scheinleiterbahn (4) ist.

2. Substrat nach Anspruch 1, dadurch gekennzeichnet, daß Scheinleiterbahnen (4) etwa parallel zu Leiterbahnen (3, 3') angeordnet sind.

3. Substrat nach einem der vorhergehenden Ansprüche, dadurch gekennzeichnet, daß die Leiterbahnen (3, 3') bzw. Scheinleiterbahnen (4) in einem Abstand zwischen 20 μm bis 500 μm angeordnet sind.

4. Substrat nach Anspruch 3, dadurch gekennzeichnet, daß die Leiterbahnen (3, 3') bzw. Scheinleiterbahnen (4) in einem Abstand von 100 μm angeordnet sind.

5. Substrat nach einem der vorgergehenden Ansprüche, dadurch gekennzeichnet, daß zwischen zwei in größerem Abstand voneinander verlaufenden Leiterbahnen (3) eine Merhzahl von Scheinleiterbahnen (4) angeordnet ist.

6. Substrat nach Anspruch 5, dadurch gekennzeichnet, daß die Scheinleiterbahnen (4) ein Raster (8) bilden.

7. Substrat nach einem der vorhergehenden Ansprüche, dadurch gekennzeichnet, daß das Substrat ein Glassubstrat (1) ist.

8. Substrat nach einem der vorhergehenden Ansprüche, dadurch gekennzeichnet, daß die Leiterbahnen (3, 3') und/oder die Scheinleiterbahnen aus Kupfer bestehen.

9. Substrat nach einem der vorhergehenden Ansprüche, dadurch gekennzeichnet, daß das Lotmaterial zinnhaltig ist.

10. Substrat nach einem der vorhergehenden Ansprüche, dadurch gekennzeichnet, daß die Lotschicht (5) der Leiterbahnen (3, 3') und Scheinleiterbahnen (4) eine Dicke von 2—50 µm aufweist.

11. Substrat nach Anspruch 10, dadurch gekennzeichnet, daß die Lotschicht (5) eine Dicke von 15 µm aufweist.

12. Substrat nach Anspruch 10, dadurch gekennzeichnet, daß die Dicke der Lotschicht (5) mit einer Toleranz von ± 3 µm aufgebracht ist.

13. Substrat nach einem der vorhergehenden Ansprüche, dadurch gekennzeichnet, daß eine großflächige Leiterbahn durch eine eine entsprechende Fläche abdeckende Mehrzahl miteinanderverbundener, feinstrukturierter Leiterbahnen (33) gebildet ist.

14. Substrat nach Anspruch 13, dadurch gekennzeichnet, daß dei großflächige Leiterbahn eine Kontaktstelle (7) für einen Steckkontakt bildet.

15. Substrat nach einem der vorhergehenden Ansprüche, dadurch gekennzeichnet, daß das Substrat eine Zellenwand einer Flüssigkristallzelle ist und die Leiterbahnen (3, 3') die Anschlüsse für Steuereinheiten bilden.

## Revendications

1. Substrat comportant à sa surface des pistes conductrices constituées par un matériau soudable, disposées avec des intervalles étroits, ainsi qu'une couche de soudure apportée sur les pistes conductrices par contact lors d'un déplacement longitudinal des pistes conductrices contre un matériau en fusion, substrat caractérisé en ce qu'à côte des pistes conductrices (3, 3') sont prévues sur le substrat de fausses pistes conductices (4), qui correspondent par leur structure à une piste conductrice (3, 3') mais ne remplissent aucune fonction électrique, les pistes conductrices (3, 3') et les fausses pistes conductrices (4) étant disposées de façon que, lors de l'apport de la couch (5) de soudure sur les pistes conductrices (3, 3') et les fausses pistes conductrices (4), le matériau de soudure en fusion soit toujours en contact avec une piste conductrice (3, 3') ou une fausse piste conductrice (4).

2. Substrat selon la revendication 1, caractérisé en ce que les fausses pistes conductrices (4) sont disposées approximativement parallèlement aux pistes conductrices (3, 3').

3. Substrat selon l'une des revendications précédentes, caractérisé en ce que les pistes conductrices (3, 3') ou les fausses pistes conductrices (4) sont disposées avec un intervalle compris entre 20 µm et 500 µm.

4. Substrat selon la revendication 3, caractérisé en ce que les pistes conductrices (3, 3') ou les fausses pistes conductrices (4) sont disposées avec un intervalle de 100 µm.

5. Substrat selon l'une des revendications précédentes, caractérisé en ce que plusieurs fausses pistes conductrices (4) sont disposées entre deux pistes conductrices (3) séparées par un intervalle assez important.

6. Substrat selon la revendication 5, caractérisé en ce que les fausses pistes conductrices (4) forment une trame 8.

7. Substrat selon l'une des revendications précédentes, caractérisé en ce que le substrat est un substrat (1) en verre.

8. Substrat selon l'une des revendications précédentes, caractérisé en ce que les pistes conductrices (3, 3') et/ou les fausses pistes conductrices sont en cuivre.

9. Substrat selon l'une des revendications précédentes, caractérisé en ce que le matériau de soudure contient de l'étain.

10. Substrat selon l'une des revendications précédentes, caractérisé en ce que la couche (5) de soudure des pistes conductrices (3, 3') et des fausses pistes conductrices (4) présente une épaisseur de 2 à 50 µm.

11. Substrat selon la revendication 10, caractérisé en ce que la couche (5) de soudure présente une épaisseur de 15 µm.

12. Substrat selon la revendication 10, caractérisé par le fait que l'apport de couche (5) de soudure est réalisé avec une épaisseur dont la tolérance est de ± 3 µm.

13. Substrat selon l'une des revendications précédentes, caractérisé en ce qu'une piste conductrice à grande surface est formée par un grand nombre de pistes conductrices (3') à structure fine, reliées les unes aux autres et recouvrant une surface correspondante.

14. Substrat selon la revendication 13, caractérisé en ce que la piste conductrice à grande surface forme une zone (7) de contact pour un contact à fiches.

15. Substrat selon l'une des revendications précédentes, caractérisé en ce que le substrat est une paroi de cellule à cristaux liquides et en ce que les pistes conductrices (3, 3') forment les branchements de jonction des unités de pilotage.

## Claims

1. Substrate with conductor tracks of solderable material arranged thereon at close spacings, and also with a solder layer which is applied to the conductor tracks by contact when the tracks move along molten solder material, characterised in that there are provided on the substrate adjacent to the tracks (3, 3') dummy tracks (4) which correspond in their structure to a track (3, 3') but perform no electrical conduction function, the tracks (3, 3') and dummy tracks (4) being so arranged that when the solder layer (5) is applied to the tracks (3, 3') and to the dummy tracks (4) the molten solder material is always in contact with a track (3, 3') or dummy track (4).

2. Substrate according to claim 1, characterised in that dummy tracks (4) are arranged substantially parallel to tracks (3, 3').

4

3. Substrate according to one of the preceding claims, characterised in that the tracks (3, 3') and dummy tracks (4) are arranged at a spacing of between 20 μm to 500 μm.

4. Substrate according to claim 3, characterised in that the tracks (3, 3') and dummy tracks (4) are arranged at a spacing of 100 μm.

5. Substrate according to one of the preceding claims, characterised in that a plurality of dummy tracks (4) are arranged between two tracks (3) disposed at a relatively considerable distance from one another.

6. Substrate according to claim 5, characterised in that the dummy tracks (4) form a grid (8).

7. Substrate according to one of the preceding claims, characterised in that the substrate is a glass substrate (1).

8. Substrate according to one of the preceding claims, characterised in that the tracks (3, 3') and/ or the dummy tracks (4) are made of copper.

9. Substrate according to one of the preceding claims characterised in that the solder material is a tin containing material.

10. Substrate according to one of the preceding claims, characterised in that the solder layer (5) of the tracks (3, 3') and dummy tracks (4) has a thickness of 2—50 μm.

11. Substrate according to claim 10, characterised in that the solder layer (5) has a thickness of 15 μm.

12. Substrate according to claim 10, characterised in that the thickness of the solder layer (5) is applied with a tolerance of ± 3 μm.

13. Substrate according to any one of the preceding claims, characterised in that a large area conductor track is formed by a plurality of fine structure conductor tracks (3') which are joined to each other and cover an appropriate area.

14. Substrate according to claim 13, characterised in that the large area conductor track forms a contact location (7) for a bond-contact.

15. Substrate according to one of the preceding claims, characterised in that the substrate is a cell wall of a liquid crystal cell and the conductor tracks (3, 3') form the connections for control units.

FIG.1

FIG. 2